Europäisches Patentamt

European Patent Office

Office européen des brevets

(19)

(11) Numéro de publication : **0 432 049 B1**

(12) **FASCICULE DE BREVET EUROPEEN**

(45) Date de publication du fascicule du brevet :
**10.06.92 Bulletin 92/24**

(51) Int. Cl.⁵ : **G11C 16/06,** G11C 16/04,
G11C 17/16

(21) Numéro de dépôt : **90403479.0**

(22) Date de dépôt : **06.12.90**

(54) **Fusible MOS à claquage d'oxyde tunnel programmable.**

(30) Priorité : **07.12.89 FR 8916196**

(43) Date de publication de la demande :
**12.06.91 Bulletin 91/24**

(45) Mention de la délivrance du brevet :
**10.06.92 Bulletin 92/24**

(84) Etats contractants désignés :
**DE FR GB IT**

(56) Documents cités :
**FR-A- 2 527 805**
**US-A- 3 576 549**
**COMPUTER DESIGN, vol. 22, no. 7, juin 1983,**
**pages 191-196, Winchester, MA, US; K.W.**
**POPE: "No waiting - EEPROM at work"**

(73) Titulaire : **SGS-THOMSON**
**MICROELECTRONICS S.A.**
**7, Avenue Galliéni**
**F-94250 Gentilly (FR)**

(72) Inventeur : **Sourgen, Laurent**
**Cabinet Ballot-Schmit, 7, rue Le Sueur**
**F-75116 Paris (FR)**

(74) Mandataire : **Schmit, Christian Norbert Marie**
**et al**
**Cabinet Ballot-Schmit 7, rue Le Sueur**
**F-75116 Paris (FR)**

Jouve, 18, rue Saint-Denis, 75001 PARIS

## Description

L'invention a pour objet les fusibles utilisés dans les circuits intégrés en technologie MOS.

Des fusibles sont utilisés dans de tels circuits pour les configurer. C'est à dire, pour définir à un moment donné, leurs fonctions, leurs ressources et les modes ou chemins d'accès à ces ressources...Par exemple, dans les cartes à mémoire, de tels fusibles permettent de partitionner un plan mémoire initial EPROM ou EEPROM en zones accessibles en lecture /écriture et d'autres en lecture uniquement.

Plusieurs configurations successives sont parfois nécessaires. Elles correspondent chacunes à un niveau d'utilisation particulier, cette utilisation étant plus restreinte, plus spécialisée à chaque nouvelle configuration. Par exemple, on peut définir trois niveaux d'utilisation pour une carte à puces ou à mémoire. Le premier étant celui obtenu après fabrication de la carte, que l'on peut appeler le mode usine, c'est le plus ouvert, le moins spécialisé. Il se caractérisé par peu de restrictions ou d'interdictions de chemin d'accès. La carte à puces peut-être utilisée en vue de diverses applications : téléphonie, banque...On opère donc une première configuration qui particularise la carte : par exemple on configure la carte en mode usine en vue d'une application bancaire. Elle peut alors être fournie à une banque. C'est un mode intermédiaire. Les fonctions et modes d'accès ont été limités, configurés pour correspondre aux formalités propres à une carte bancaire consignées dans un cahier de charges de la banque. Celle-ci peut alors programmer ses informations propres, secrètes comme : un numéro d'identification, de compte, les opérations autorisées..., dans une zone donnée. Elle doit ensuite interdire toute reprogrammation ultérieure de cette zone. Elle effectue donc une deuxième configuration, qui amène la carte en mode intermédiaire à un mode final, utilisateur. Elle peut alors la transmettre à un utilisateur.

Cet exemple d'utilisation non exhaustif rend cependant bien compte de l'intérêt des fusibles qui permettent la configuration, mais aussi du caractère fiable et sécuritaire dont ces fusibles doivent être pourvus, pour assurer le caractère irréversible des configurations successives ou non d'un circuit intégré: une fonctionnalité ne peut être modifiée d'aucunes façons. En effet, pour ne citer qu'un exemple, il ne doit pas être possible à l'utilisateur de modifier les informations secrètes.

On connaît différents fusibles utilisables dans les circuits intégrés, réalisés par exemple sous forme d'une très fine couche de silicium polycristallin et alimentés en courant, par exemple par un transistor. Quand un courant circule pendant un certain temps, un échauffement local se produit à cause de la section très fine du fusible. Cet échauffement suffit à volatiliser le métal : le fusible est claqué. En fait, il arrive que le fusible ne claque pas. En pratique, un tel fusible n'est pas fiable.

Il convient par ailleurs de noter l'utilisation très répandue des mémoires EPROM et surtout EEPROM dans les cartes à puces. La nécessité en effet de garder trace de certaines informations, opérations dans une carte à puces tantôt sous-tension (dans le lecteur), tantôt hors-tension, a exclu l'utilisation des mémoires RAM, volatiles et ROM, non volatiles mais programmables par masque, à la fabrication.

La non-nécessité de garder en permanence la trace de toutes les opérations, mais pour certaines, comme le solde du compte pour une application bancaire, seulement d'une utilisation à l'autre de la carte à puces, a donné un certain avantage à la mémoire EEPROM, effaçable électriquement dans le lecteur. L'impossibilité d'effacer sur le site du lecteur une mémoire EPROM conduit en effet à une consommation de toute la mémoire programmable qui oblige à changer de carte quand cette mémoire a été entièrement programmée. Or si la notion de carte jetable est encore de mise, on lui préfère la notion de carte rechargeable sur le site, en particulier, pour de simples motifs économiques. Un avantage d'un fusible selon l'invention est de faire partie d'un tel plan mémoire EEPROM.

Dans l'invention, on réalise un fusible en utilisant les propriétés connues des cellules mémoires EEPROM. Selon l'invention les fusibles non claqués sont semblables a une cellule mémoire : ils font partie du plan mémoire. Ce ne sont pas des ressources supplémentaires, différentes, et leur mode d'accès est celui des cellules mémoires du plan mémoire. C'est par une programmation d'une cellule mémoire que celle-ci pourra être l'équivalent d'un fusible dit claqué.

En effet, l'invention a pour objet un fusible MOS programmable comportant une cellule mémoire EEPROM à oxyde tunnel d'un plan mémoire composé de cellules semblables, un régulateur de tension de programmation /effacement Vpp fournissant, par programmation d'une commande de commutation, une tension de programmation /effacement Vpp à front lent ou à front raide, un front lent permettant une programmation/effacement normale de la cellule mémoire, un front raide claquant l'oxyde tunnel et mettant alors la cellule mémoire dans un état irréversible.

L'invention sera mieux comprise et d'autres caractéristiques apparaîtront à l'aide de la description qui suit, donnée à titre d'exemple indicatif et nullement limitatif de l'invention et en référence aux figures annexées, dans lesquelles :

– la figure 1 est un schéma en coupe d'une cellule MOS programmable à grille flottante,

– la figure 2 est un schéma électrique correspondant à la programmation normale ou en fusible d'une cellule mémoire EEPROM, selon l'invention,

– la figure 3 est un schéma-bloc d'un exemple de réalisation d'un générateur de tension de programmation à front raide ou lent,

– les figures 4.a et 4.b sont des diagrammes temporels de signaux électriques correspondant à la figure 3.

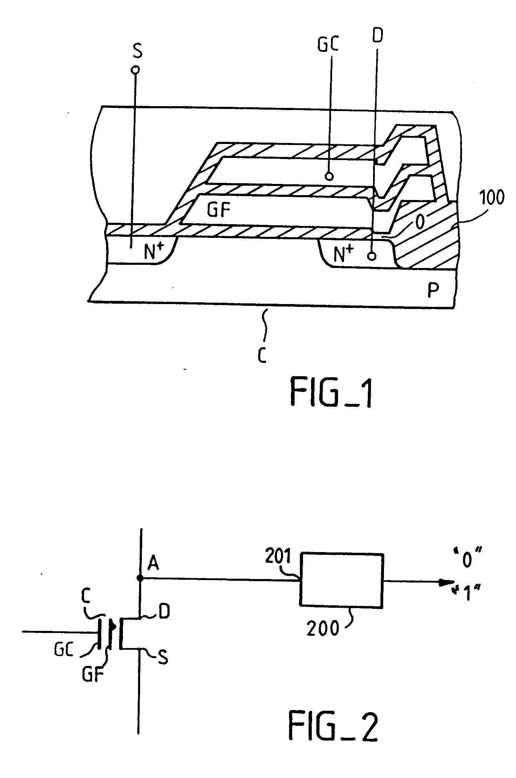

La figure 1 est un schéma en coupe d'une cellule MOS EEPROM C connue. Elle comporte une zone source S, une zone drain D, qui sont des diffusions par exemple $N^+$ dans un substrat P. Elle comporte en outre une grille de contrôle GC qui recouvre une grille flottante GF, toutes deux en silicium polycristallin. La grille flottante GF est noyée dans de l'oxyde de silicium 100 qui l'isole en particulier de la grille de contrôle GC et du substrat. En fait, l'oxyde de silicium se comporte comme un diélectrique, d'une part entre la grille de contrôle GC et la grille flottante GF et d'autre part entre la grille flottante GF et le drain D ou la source S, ou encore le substrat. On parle de couplage capacitif.

D'une manière préférée, une région d'oxyde tunnel O est réalisée au niveau du drain D. C'est une région d'oxyde de silicium plus mince au niveau du drain et qui facilite le transfert des charges entre le drain D et la grille flottante GF et inversement, sous l'effet d'un champ électrique. L'oxyde tunnel facilite donc la programmation et l'effacement d'une telle cellule mémoire.

En effet, effacer la cellule C consiste à porter sa grille de contrôle GC à un potentiel très positif Vpp, de l'ordre de 20 volts, et son drain D à la masse électrique Vss du circuit. Par couplage capacitif entre la grille de contrôle GC et la grille flottante GF, on porte également la grille flottante GF à un potentiel très positif, de l'ordre de 10 volts. On crée ainsi un champ électrique intense entre la grille flottante et le drain D, la source S de la cellule n'étant pas connectée, c'est-à-dire "en l'air" : des électrons sont alors piégés sous la grille flottante GF. Ils induisent une barrière de potentiel qui s'oppose à la conduction de la cellule mémoire : la tension de seuil de la cellule est élevée, de l'ordre de 5 volts. On rappelle que la tension de seuil est la tension minimale qu'il faut appliquer sur la grille de contrôle GC, pour que la cellule mémoire C se mette à conduire.

Programmer une cellule EEPROM effacée consiste à faire partir les électrons stockés sous la grille flottante GF : on inverse le sens du champ électrique précédemment appliqué. Ainsi le drain D est porté au potentiel Vpp et la grille de contrôle GC au potentiel Vss, la source S étant toujours non connectée : les électrons piégés sont alors évacués. Pour être sûr de la programmation, on maintient le champ électrique suffisamment longtemps. Ce faisant, on fait également partir de la grille flottante des électrons libres qui contribuaient à la neutralité électrique du matériau de la grille flottante. De cette manière, on importe en quelque sorte des trous dans la grille flottante.

Lire la cellule mémoire C consiste à appliquer une tension de lecture Vl sur la grille de contrôle GC et une tension Vcc de l'ordre de 5 volts sur le drain D. Vl vaut typiquement 1,5 volts. Enfin, un circuit de lecture 200 (figure 2), centré sur une tension de seuil comprise entre 0 et 5 volts, en général 2,5 volts, a son entrée 201 reliée au drain D, en un point A. Ce circuit de lecture va par exemple détecter un "1" si la cellule est programmée, un "0" si elle est effacée. La cellule programmée se comporte en effet comme un circuit fermé, puisque la tension Vl sur sa grille de contrôle GC est supérieure à sa tension de seuil de l'ordre de -2volts. La tension au point A chute et c'est cette chute qui est détectée par le circuit de lecture.

La cellule effacée se comporte, elle, comme un circuit ouvert, la tension Vl étant alors inférieure à sa tension de seuil de l'ordre de 5 volts : la tension au point A ne chute pas.

Cependant la programmation et l'effacement, qui sont des opérations d'écriture de la cellule, sont des opérations délicates. L'oxyde tunnel O est en effet fragile, du fait de sa faible épaisseur (90 Angströms). Aussi utilise t'on un régulateur de tension RG qui calibre le potentiel Vpp. Ainsi on peut éviter tous pics ou surtensions qui pourraient endommager l'oxyde et réduire alors le nombre d'opérations de programmation et d'effacement possibles; en pratique, on assure de plus une commutation lente du potentiel Vpp : le temps de montée typique est de l'ordre de 2ms. Ces conditions de programmation/ effacement permettent de réaliser de l'ordre de 100 000 opérations de programmation/ effacement, avant que la cellule ne soit déclarée "morte".

Dans l'invention, par une commande de commutation Ccom, le régulateur de tension RG délivre un signal Vpp soit à front lent fl($\approx$2ms), soit à front raide fr(100$\mu$s) et bien calibré (pas de surtensions). Un tel signal va alors claquer l'oxyde tunnel, c'est-à-dire le percer, court-circuitant ainsi le drain D et la grille flottante GF, sans endommager le reste de la cellule ou la circuiterie associée. Et ceci étant donc causé par l'application brutale (front raide) du potentiel Vpp.

Le court-circuit crée entre le drain D et la grille flottante GF est irréversible. Il n'est possible d'aucunes manières de reconstituer l'oxyde tunnel O : c'est un état irréversible. Mais quel est donc cet état?

Le court-circuit entre le drain D et la grille flottante GF ne permet plus de stockage de charges positives ou négatives sur cette grille flottante GF : la tension de seuil correspondante est alors sensiblement nulle.

Une lecture de la cellule "claquée" avec un circuit tel que décrit précédemment, donne donc une sortie logique " 1 ", soit un état dit programmé. En effet, dans ce circuit de lecture, la tension de lecture Vl appliquée à la grille vaut environ 1,5 volts : VL est supérieure à la tension de seuil nulle de la cellule claquée. La cellule C claquée va donc conduire et la tension au point A, chuter (figure 2).

Avec un autre type de circuit de lecture, utilisant par exemple une valeur de VI de l'ordre de -1 volts, on lirait alors une cellule dite effacée (qui ne conduit pas).

Dans tous les cas, on obtient un état irréversible et "distinguable" par lecture, d'un précédent état : on a un fusible à claquage d'oxyde tunnel programmable par une commande de commutation Ccom front lent/front raide. Il est donc programmable à tout moment dans une application.

De plus, c'est un fusible à deux états de fonctionnement : avant d'être claqué, il est une cellule mémoire indifférenciée d'un plan mémoire non représenté. Ceci permet de valider la circuiterie associée à la cellule (accès, décodage, programmation/effacement, lecture), et d'augmenter la fiabilité d'un tel fusible selon l'invention. En effet les fusibles classiques ont un état initial, et un état final irréversible. Dans l'invention, un fusible a d'abord un état initial et un état final réversibles, puis par programmation (ou commutation) d'un front raide, un état final irréversible. On peut aussi dire que l'on dispose alors, dans le plan mémoire, de cellules qui peuvent être dans trois états : effacées, programmées ou claquées. On a conjugué les qualités de programmation et d'effacement électriques d'une cellule mémoire EEPROM et celle d'irréversibilité d'un fusible, pour obtenir un fusible programmable à la demande et très fiable.

Il est en pratique possible qu'un seul front raide ne suffise pas à claquer le fusible de l'invention. Il suffit alors de relire l'état de la cellule, et de réappliquer un front raide, si la cellule n'est pas claquée. Ceci suppose bien sûr de partir de l'état différent de celui dans lequel la cellule se trouve après claquage, cet état étant celui lu par le circuit de lecture. Dans l'exemple d'une tension de lecture VI de 1,5 volts, il faut que la cellule soit effacée avant de procéder à la commutation du front raide.

On peut ainsi avoir jusqu'à 10 applications successives d'un front raide du signal Vpp, soit 10 boucles par exemple d'une programmation suivie d'une lecture. Cet "algorithme de claquage" peut aisément être géré par micro-processeur. Ou bien, on peut choisir d'appliquer systématiquement 10 fronts raides successifs en utilisant par exemple un compteur.

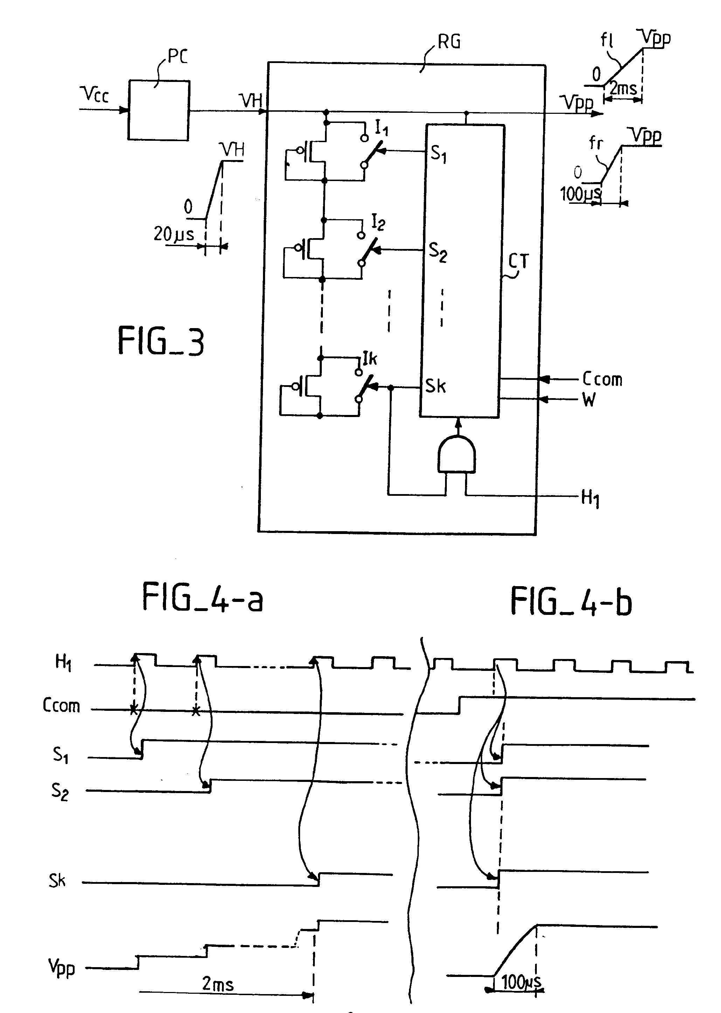

Les figures 3, 4.a et 4.b décrivent un exemple de régulateur de tension RG qui permet d'obtenir un signal Vpp à front lent ou raide selon l'invention, par programmation. On a vu que les circuits de programmation/effacement utilisent un régulateur de tension Vpp pour bien calibrer ce signal. De manière connue, ce régulateur est alimenté par une tension externe ou de préférence par un élévateur de tension (pompe de charge) qui reçoit la tension Vcc du circuit (≈5 volts) et établit une tension VH supérieure de manière rapide (par exemple 20µs), et qui est intégré au circuit. La tension VH fournie par la pompe de charge est égale ou supérieure à la tension Vpp. Par exemple elle peut valoir 25 volts.

Classiquement un régulateur est constitué, dans un 1er étage, d'une chaîne de transistors montés en diodes (grille et drain court-circuités) pour établir chacun entre sa source et son drain, une tension égale à sa tension de seuil. Selon la technologie mise en oeuvre, la tension de seuil varie et le nombre de transistors en série permet de définir la tension régulée en sortie du régulateur.

Par exemple, pour une tension de seuil de l'ordre de 1 volt des transistors en série montés en diode, il faut 20 transistors pour établir une tension régulée Vpp de l'ordre de 20 volts.

En sortie du 1er étage on a un circuit analogique qui constitue le 2ème étage du régulateur.

Ce circuit reçoit la tension de sortie du 1er étage et fournit une tension en forme de rampe croissante de O à une valeur Vpp.

La pente de croissance est d'environ 1 à 2 millisecondes pour aller à Vpp : c'est le signal Vpp à front lent.

Pour obtenir un front raide, il suffit alors d'utiliser un deuxième circuit analogique, dont les paramètres seraient calculés pour fournir une pente de croissance d'environ $100\mu s$ pour aller de O à Vpp.

Il suffit alors d'actionner un commutateur par la commande de commutation Ccom pour sélectionner un front raide ou un front lent. Mais ces circuits analogiques sont complexes (typiquement plusieurs dizaines de transistors), encombrants (ils utilisent des capacités) et ils sont très dépendants des paramètres de réalisation technologiques et de la température.

Aussi propose-t'on un autre mode de réalisation préféré, qui comporte un moyen de commande numérique. Le régulateur RG (figure 3) comprend dans un premier étage un ensemble de k transistors en série, chaque transistor étant monté en diode, avec sa grille reliée à son drain, de manière à ce que s'établisse entre drain et source de chaque transistor une tension égale à la tension de seuil de ce transistor; il s'établit donc aux bornes de l'ensemble en série des k transistors, dès lors que la tension aux bornes de cet ensemble les met en régime de saturation, une tension égale à la somme des tensions de seuil de tous les transistors, c'est-à-dire égale à k fois la tension de seuil des transistors s'ils ont tous la même tension de seuil Vtp.

Dans l'exemple représenté, l'ensemble en série comprend k transistors à canal P pour une réalisation sur substrat P, chacun des transistors étant réalisé dans un caisson séparé des autres pour avoir une tension de seuil plus stable (suppression de l'effet dit "de substrat" sur la tension de seuil). Une extrémité de l'ensemble en série des transistors P est reliée au potentiel de masse Vss. L'autre extrémité est reliée à la tension de sortie VH de la pompe de charge PC.

Le régulateur, ainsi constitué d'un ensemble de transistors en série monté entre la tension VH et la masse Vss, limite la tension VH à une tension kVtp. Selon la valeur de tension Vpp désirée et selon la valeur des tensions de seuil des transistors P, on choisit le nombre k de transistors nécessaire.

On pourrait éventuellement avoir k transistors P et k' transistors N. Toutefois on aurait une moins bonne stabilité de tension régulée.

Dans un exemple numérique, la tension de seuil Vtp est de l'ordre de 1 volt. Une vingtaine de transistors P sont nécessaires pour avoir une tension Vpp d'une vingtaine de volts.

Le temps de montée du signal Vpp est obtenu par commande numérique de ces transistors. Cette commande numérique utilise un compteur CT pour fournir un temps de montée selon un profil désiré. C'est le 2ème étage du régulateur.
Le compteur CT a k sorties S1, S2, S3 ... Sk. Le compteur est commandé par une horloge H1.

Les sorties du compteur commandent des interrupteurs I1, I2, ... Ik, capables de court-circuiter ou décourt-circuiter chacun des transistors de l'ensemble en série de k transistors du régulateur. Ce compteur fonctionne en comptage/décomptage, la sélection du sens de comptage étant commandée par la commande de commutation du régulateur, Ccom.

Quand c'est le front lent qui est sélectionné par Ccom et de préférence, c'est le front lent qui est sélectionné à la mise sous tension, le compteur fonctionne en comptage. Ainsi, la sortie S1 permet de court-circuiter le transistor P le plus proche de Vpp, la sortie S2 le suivant, etc, et la sortie Sk permet de court-circuiter le transistor P relié à Ta masse. Les niveaux logiques présents sur les sorties S1, S2 ... Sk, sont entre 0 volt et la haute tension Vpp, le compteur étant par conséquent alimenté par la tension Vpp produite.

Le comptage se déclenche lors de l'ordre de production d'une tension Vpp, ordre fourni par exemple par un signal d'écriture W de la cellule mémoire. Le compteur a initialement toutes ses sorties dans un état logique tel qu'elles court-circuitent tous les transistors. Dans l'exemple représenté, les interrupteurs commandés par les sorties du compteur sont des transistors à canal N et sont court-circuités par une tension de niveau haut sur leur grille. On supposera donc qu'au départ les sorties du compteur fournissent toutes un état logique haut.

Le signal W autorise alors le comptage par le compteur. Le compteur n'est pas un compteur binaire (ou s'il l'est il est suivi d'un décodeur); il établit au premier coup d'horloge un état bas sur la sortie S1, puis, au deuxième coup d'horloge, un état bas sur la sortie S2 sans modifier l'état bas de S1, et ainsi de suite, il établit un état bas sur chacune des sorties successives jusqu'à Sk en laissant à chaque fois la sortie précédente dans l'état où il l'a mise au coup d'horloge précédent. En vingt coups d'horloge, dans un exemple avec vingt transistors P, les sorties sont toutes passées à l'état bas et tous les transistors du régulateur sont décourt-circuités.

Lorsque la dernière sortie Sk passe à l'état bas elle bloque le comptage (par exemple en bloquant l'horloge H1), de sorte que le régulateur reste dans cette configuration, jusqu'à la fin de l'ordre de production de Vpp, ou même, en pratique, jusqu'à un nouvel ordre d'élaboration de Vpp (nouveau signal d'écriture W).

Il en résulte que même si la pompe de charge produit très rapidement une tension élevée, ce qui est le cas en pratique (≈20µs par exemple), le régulateur va limiter cette tension à une valeur qui sera 0 puis Vtp, puis 2Vtp, etc, jusqu'à kVtp c'est-à-dire la tension Vpp finale désirée.

La tension Vpp ainsi limitée par le régulateur à seuil variable va monter en escalier au rythme de l'horloge H1 (qu'il est facile de contrôler précisément).

Quand c'est le front raide qui est sélectionné par Ccom, le compteur fonctionne en décomptage. Ainsi, les sorties S1 à Sk décourt-circuitent tous les transistors P en même temps.

Le décomptage se déclenche lui aussi lors de l'ordre de production d'une tension Vpp, fourni dans l'exemple par le signal W. Le compteur a initialement toutes ses sorties dans un état logique haut : elles court-circuitent tous les transistors N (interrupteurs I1,.. .Ik).

Le signal W autorise alors le décomptage par le compteur.

Le décomptage est stoppé après le premier coup d'horloge H1. En effet, le premier décomptage fait passer toutes les sorties du compteur au niveau logique bas. Or, on a prévu que lorsque la dernière sortie Sk passe à l'état bas elle bloque l'horloge H1 : elle bloque donc le décomptage. De cette manière, le régulateur reste dans cette configuration, jusqu'à la fin de l'ordre de production de Vpp, ou même, en pratique, jusqu'à un nouvel ordre d'élaboration de Vpp (nouveau signal d'écriture W). On pourrait bloquer le décomptage sur le passage à l'état bas d'une quelconque sortie S1 à Sk, puisqu'elles changent toutes d'état en même temps.

Les figure 4.a et 4.b représentent cette croissance de la tension limite du régulateur (donc la croissance de Vpp) en relation avec les commutations successives (figure 4.a) ou simultanées (figure 4.b) de l'état logique des sorties S1 à Sk du compteur CT.

Si on a 20 transistors à canal P, les tensions de seuil étant de 1 volt environ, le compteur aura 20 sorties. En comptage, pour obtenir une tension passant de 0 à 20 volts environ en un peu moins de 2 millisecondes, il faudra prendre une horloge H1 de 10 kilohertz. En décomptage, le temps de montée qui est de une période d'horloge, sera alors de l00µs. Plus généralement, pour obtenir un temps de montée lent Tm avec un compteur à k sorties et un régulateur ayant k tensions limites possibles, on utilisera une horloge de fréquence k/Tm. La fréquence pourra être entre k/2 et k kilohertz pour un temps de montée de 1 à 2 millisecondes. Le temps de montée rapide est lui de Tm/k.

L'expérience montre que les échelons de la tension Vpp obtenus par le comptage (front lent), ne sont pas très gênants; d'une part ils n'existent que pendant la phase transitoire de montée de Vpp; d'autre part les nombreuses résistances et capacités parasites des circuits que Vpp est destinée à alimenter atténuent très fortement ces échelons.

Par ailleurs, un régulateur RG à commande numérique tel que décrit permet d'utiliser pour le claquage une tension Vpp à front raide, de valeur supérieure à celle à front lent. Par exemple, la tension Vpp à front raide peut être supérieure de quelques Vtp à la tension Vpp à front lent. Il suffit en effet de disposer dans le premier étage de k+n transistors P en série, montés en diode, et d'un compteur à n+k sorties ( S1 à Sk+n). En comptage (obtention d'un front lent), seuls les k premiers transistors sont successivement décourt-circuités selon le principe déjà décrit. Par contre, en décomptage, les n+k transistors sont tous décourt-circuités en même temps : dans le premier cas Vpp vaut kvtp, dans le second cas Vpp vaut (k+n)Vtp. Si k vaut 20 et n vaut 5, on a par exemple une tension Vpp égale à environ 20 volts pour la programmation et l'effacement, et égale à environ 25 volts pour le claquage de la cellule mémoire. Ceci est possible à condition toutefois que la valeur VH fournie à l'entrée du régulateur soit au moins égale à la valeur recherchée, 25 volts dans l'exemple. Le régulateur ne peut délivrer en effet en sortie qu'une tension au maximum égale à VH.

Une telle tension de claquage supérieure combinée à un front raide permet d'améliorer le claquage de l'oxyde tunnel. L'arrêt du comptage et du décomptage peut toujours se faire sur le passage à l'état bas de la sortie Sk du compteur puisque pour le décomptage, les états sur les sorties S1 à Sk+n sont établis tous en même temps.

De même, un compteur pour lequel on peut initialiser une valeur, par programmation par exemple d'un registre du compteur, dans un régulateur selon l'invention, est du domaine de l'invention. Cette possibilité permet par exemple de choisir par programmation du compteur, la valeur de Vpp pour le claquage. Par exemple cette valeur peut être égale à kVtp, ou (k+1)Vtp ... et initialisée par programmation dans le compteur. Par exemple, la valeur de claquage peut être déterminée par l'algorithme de claquage.

## Revendications

1. Fusible MOS programmable comportant une cellule mémoire EEPROM (C) à oxyde tunnel (O) d'un plan mémoire composé de cellules semblables, un régulateur de tension (RG) de programmation /effacement (Vpp) fournissant, par programmation d'une commande de commutation (Ccom), une tension de programmation /effacement (Vpp) à front lent (fl) ou à front raide (fr), un front lent permettant une programmation/effacement normale de la cellule mémoire (C), un front raide claquant l'oxyde tunnel et mettant alors la cellule mémoire dans un état irréversible.

2. Fusible selon la revendication 1, caractérisé en ce que le régulateur de tension (RG) comprend un ensemble de transistors en série, montés en diode et établissant entre source et drain une tension égale à leur tension de seuil (Vtp) et en ce qu'un moyen de commande numérique comprend un compteur (CT) apte à établir un état logique déterminé sur chacunes de ses sorties, soit successivement pour une commande de commutation (Ccom) d'un front lent (fl), soit en même temps pour une commande de commutation d'un front raide (fr), et un moyen ($I_1$ à $I_K$) commandé par les sorties du compteur pour initialement court-circuiter les transistors montés en diode, puis les décourt-circuiter soit progressivement les uns après les autres au fur et à mesure du comptage pour avoir un front lent, soit tous en même temps par décomptage pour avoir un front raide.

3. Fusible selon la revendication 2, caractérisé en ce que le compteur est un circuit à k sorties, qui, en comptage, établit à chaque coup d'horloge un niveau logique déterminé sur une nouvelle sortie, en laissant à chaque fois le niveau établi sur la sortie précédente et qui, en décomptage, établit à chaque coup d'horloge un niveau logique déterminé sur toutes les sorties, et en ce qu'il est prévu un moyen pour arrêter le comptage et le décomptage lorsque la dernière sortie a été mise au niveau déterminé.

4. Fusible selon la revendication 2, caractérisé en ce que le compteur est un circuit à k+n sorties, qui, en comptage, établit sur les k premières sorties (S1,..Sk) de rangs 1 à k, les unes après les autres, à chaque coup d'horloge un niveau logique déterminé sur une nouvelle sortie, en laissant à chaque fois le niveau établi sur la sortie précédente et qui, en décomptage, établit à chaque coup d'horloge un niveau logique déterminé sur toutes les k+n sorties (S1 à Sk+n), et en ce qu'il est prévu un moyen pour arrêter le comptage et le décomptage lorsque la sortie de rang k a été mise au niveau déterminé.

## Patentansprüche

1. Programmierbare MOS-Sicherung mit einer EEPROM-Speicherzelle (C) auf Tunneloxidbasis (O) einer aus identischen Zellen bestehenden Speicherebene, einem Spannungsregler (RG) zur Programmierung und zur Löschung (Vpp), der bei der Einprogrammierung eines Schaltbefehls (Ccom) eine Spannung zur Einprogrammierung und zur Löschung (Vpp) mit flacher oder steiler Vordeiflanke (fl bzw. fr) liefert, wobei eine flacher Vorderflanke eine normale Programmmierung oder Löschung der Speicherzelle (C) ermöglicht, während eine steile Vorderflanke das Tunneloxid durchschlagen läßt, so daß die Speicherzelle in einen nichtreversiblen Zustand versetzt wird.

2. Sicherung nach Anspruch 1, dadurch gekennzeichnet, daß der Spannungsregler (RG) mehrere in Diodenschaltung liegende Reihentransistoren aufweist, die zwischen der source und dem Drain eine Spannung aufbauen lassen, die deren Schwellenspannung (Vtp) entspricht und daß eine digitale Steuerungseinrichtung einen Zähler (CT) aufweist, die geeignet ist, einen gegebenen logischen Zustand an jedem seiner Ausgänge entweder nacheinanderfolgend im Falle eines Schaltbefehls (Ccom) mit einer flachen Vorderflanke (fl) oder gleichzeitig im Falle eines Schaltbefehls mit einer steilen Vorderflanke (fr), festzustellen, sowie eine Einrichtung ($I_1$ bis $I_k$) umfaßt, die durch die Ausgänge des Zählers gesteuert wird, um anfänglich die in Diodenschaltung liegende Transistoren kurzzuschließen und danach deren Kurzschließung entweder nacheinander im Schritt mit der Aufwärtszählung unter Erzeugung einer flachen Vorderflanke oder gleichzeitig durch Abwärtszählen unter Erzeugung einer steilen Vorderflanke aufzuheben.

2. Sicherung nach Anspruch 2, dadurch gekennzeichnet, daß der Zähler eine Schaltung mit k Ausgängen ist, die beim Zählen bei jedem Impuls des Taktgebers einen vorgegebenen Logikzustand an einem anderen Ausgang erzeugt, ohne daß jedesmal der am vorhergehenden Ausgang herbeigeführte Zustand verändert wird und die beim Abwärtszählen bei jedem Taktimpuls einen neuen vorgegebenen Logikzustand an allen Ausgängen herbeiführt, und daß sie mit einer Einrichtung versehen ist, um das Zählen dann anzuhalten, wenn der letzte Ausgang in den vorgegebenen Zustand gebracht worden ist.

4. Sicherung nach Anspruch 2, dadurch gekennzeichnet, daß der Zähler eine Schaltung mit k + n Ausgängen darstellt, die beim Zählen an k ersten Ausgängen (S1,..Sk) der Ordnungen 1 bis k nacheinanderfolgend und bei jedem Taktimpuls einen vorgegebenen Logikzustand bei einem neuen Ausgang herbeiführt, ohne daß jedesmal der am vorhergehenden Ausgang herbeigeführte Zustand verändert wird und die beim Abwärtszählen bei jedem Taktimpuls einen neuen vorgegebenen Logikzustand an allen k + n Ausgängen (S1 bis Sk + n) herbeiführt, und daß sie mit einer Einrichtung versehen ist, um das Auf- und Abwärtszählen dann anzuhalten, wenn der Ausgang der Ordnung k in den vorgegebenen Zustand gebracht worden ist.

## Claims

1. A programmable MOS fuse comprising a tunnel oxide (O) EEPROM memory cell (C) in a memory array composed of similar cells, a controller (RG) of the programming/erasure voltage (Vpp) supplying, by programming a command for switching (Ccom), a programming/erasure voltage (Vpp) having a gently sloping edge (fl) or a steeply sloping edge (fr), a gently sloping edge allowing a normal programming/erasure of the memory cell (C) and a steeply sloping edge breaking down the tunnel oxide and thus putting the memory cell in an irreversible state.

2. A fuse as claimed in claim 1, characterized in that the voltage controller (RG) comprises a set of transistors in series, mounted to act as diodes and establishing between the source and the drain a voltage equal to their threshold voltage (Vtp) and in that a digital control means comprises a counter (CT) adapted to establish a defined logic state on each of its outputs, either successively in the case of a command for switching (Ccom) when a gently sloping edge (fl) is concerned or simultaneously in the case of a command for switching when a steeply sloping edge (fr) is concerned, and a means ($I_1$ to $I_k$) controlled by the outputs of the counter initially to short circuit the transistors mounted to act as diodes then to open the short circuits, either progressively one after the other as the counting proceeds in order to produce a gently sloping front, or all at the same time by counting down in order to produce a steeply sloping edge.

3. A fuse as claimed in claim 2, characterized in that the counter is a circuit comprising k outputs which on each pulse of the clock during counting establishes a defined logic level on a new output whilst leaving, each time, the level established on the preceding output, and which during counting down on each pulse of the clock establishes a defined logic level on all the outputs, and in that a means is provided for stopping the counting and the counting down when the last output has been set at the defined level.

4. A fuse as claimed in claim 2, characterized in that the counter is a circuit comprising k+n outputs which, during counting, on each pulse of the clock establishes a defined logic level on a new output, one after the other, on the k first outputs (S1, .. Sk) which have the order numbers 1 to k, whilst leaving each time the level established on the preceding output, and which, during counting down, on each pulse of the clock establishes a defined logic level on all the k+n outputs (S1 to Sk+n), and in that a means is provided for stopping the counting and the counting down when the output of order k has been set at the defined level.

FIG_1

FIG_2

FIG_3

FIG_4-a

FIG_4-b